# EUROPEAN PATENT APPLICATION

(11) **EP 4 597 836 A1**
(43) Date of publication of application: **06.08.2025**
(21) Application number: 25153056.4
(22) Date of filing: 21.01.2025
(51) Int. Cl.: H03F 1/02, H03F 1/56, H03F 3/195, H03F 3/21, H03F 3/24

(54) **MULTI-MODE POWER AMPLIFIER FOR LOAD IMPEDANCE VARIATION**

(30) Priority: 30.01.2024 US 202418427631
(71) Applicant: Analog Devices International Unlimited Company, Limerick (IE)
(72) Inventor: ESMAEL, Mohamed Moussa Ramadan, Limerick (IE)
(74) Representative: Yang, Shu

(57) **Abstract**

Aspects of this disclosure relate to a multi-mode power amplifier circuit. The power amplifier circuit can include a first power amplifier core, a second power amplifier core, an output combiner, and an adjustable termination impedance circuit connected to a port of the output combiner. The adjustable termination circuit can provide different terminations for different modes of the multi-mode power amplifier circuit. In certain embodiments, the different modes can include a Doherty mode, a segmented mode, and/or a balanced mode. The multi-mode power amplifier circuit can operate in different modes based one or more of load impedance, voltage standing wave ratio variation, or beam angle in certain applications.

## Description

### BACKGROUND

### TECHNICAL FIELD

The disclosed technology relates to radio frequency systems and power amplifiers. Embodiments of this disclosure relate to a multi-mode power amplifier.

### DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency signal for transmission via one or more antennas. Power amplifiers can encounter technical challenges related to efficiency, output power, and/or linearity. High performance power amplifiers are desired.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a power amplifier system that includes a first power amplifier core, a second power amplifier core, an output combiner, and an adjustable termination impedance circuit. The first power amplifier core is configured to provide a first radio frequency signal. The second power amplifier core is configured to provide a second radio frequency signal. The output combiner is configured to receive the first radio frequency signal and the second radio frequency signal. The output combiner includes an output port and an isolation port. The adjustable termination impedance circuit is electrically connected to the isolation port. The adjustable termination impedance circuit is configured to provide different terminations to the isolation port in different modes. The different modes include a segmented power amplifier mode.

The different modes can include a Doherty mode. The different modes can include a balanced mode.

The adjustable termination impedance circuit can be configured to adjust a termination impedance at the isolation port based on an indication of voltage standing wave ratio (VSWR) variation.

The different modes can include three modes. The three modes can include a Doherty mode, the segmented power amplifier mode, and a balanced mode. The power amplifier system can operate in a Doherty mode for voltage standing wave ratio (VSWR) variations in a range for Doherty mode, operate in the segmented power amplifier mode for VSWR variations greater than the Doherty mode and below VSWR variations for a balanced mode, and operate in the balanced mode for VSWR variations greater than for the segmented power amplifier mode.

The adjustable termination impedance circuit can provide a resistive termination in the segmented power amplifier mode and a low impedance or high impedance termination in another mode. For instance, the adjustable termination impedance circuit can provide a resistive termination in the segmented power amplifier mode and a short circuit termination in another mode. The adjustable termination impedance circuit can provide a first resistive termination in the segmented power amplifier mode and a termination impedance in a range from 25 Ohm to 100 Ohm in another mode. For instance, the adjustable termination impedance circuit can provide a first resistive termination in the segmented power amplifier mode and a 50 Ohm termination in another mode.

The first power amplifier core can be biased differently than the second power amplifier core in the segmented power amplifier mode. Both the first power amplifier core and the second power amplifier core can be activated throughout the segmented power amplifier mode.

The adjustable termination impedance circuit can provide a resistive termination in the segmented power amplifier mode. The power amplifier system can adaptively bias the second power amplifier core in the segmented power amplifier mode. A bias signal for the second power amplifier core can include at least one first tone component with a non-zero frequency to cancel a non-linearity of the second power amplifier core in the segmented mode.

The power amplifier system can include an antenna array. The power amplifier system can be configured to perform beam scanning using the antenna array. The adjustable termination impedance circuit can be configured to adjust a termination impedance at the isolation port based on an indication of a beam angle. The power amplifier system can include a second multi-core power amplifier operable in the different modes. The second multi-core power amplifier can be configured to drive a second antenna of the antenna array. The second multi-core power amplifier can be configured to operate in a same mode as the first and second power amplifier cores.

The output combiner can be a hybrid combiner. The hybrid combiner can be configured to combine the second radio frequency signal with a phase shift in a range from 60 degrees to 130 degrees relative to the first radio frequency signal. For instance, the hybrid combiner can be configured to combine the second radio frequency signal with a phase shift of 90 degrees relative to the first radio frequency signal.

The power amplifier system can include a hybrid input splitter configured to phase shift the second radio frequency signal by an angle in a range from 60 degrees to 130 degrees relative to the first radio frequency signal.

The first power amplifier core can be included in a first power amplifier segment. The first power amplifier segment can include a first input matching circuit connected to an input of the first power amplifier core and a first adaptive bias circuit connected to the first power amplifier core. The first input matching circuit and the first adaptive bias circuit can be adjustable in the different modes. The second power amplifier core can be included in a second power amplifier segment. The second power amplifier segment can include a second input matching circuit connected to an input of the second power amplifier core and a second adaptive bias circuit connected to the second power amplifier core. The second input matching circuit and the second adaptive bias circuit can be adjustable in the different modes. The first input matching circuit can include at least one controllable passive component. The first input matching circuit can be adjusted based on an indication of at least one of a reflected power change or load voltage standing wave ratio (VSWR) change. The first input matching networks and/or the second input matching network can be controlled to provide a phase shift between an input signal for the first power amplifier core and the second power amplifier core to increase and/or maximize the combined output signal after the output combiner. The first adaptive bias circuit and the second adaptive bias circuit can each generate a respective bias signal that includes a direct current (DC) bias component and at least one non-DC radio frequency tone. A magnitude of DC bias component and a magnitude of the non-DC radio frequency tone are adjusted based on an indication of a reflected power change.

Another aspect of this disclosure is a power amplifier system that includes a first power amplifier core, a second power amplifier core, a hybrid combiner, and an adjustable termination impedance circuit. The first power amplifier core is configured to provide a first radio frequency signal. The second power amplifier core is configured to provide a second radio frequency signal. The hybrid combiner is configured to receive the first radio frequency signal and the second radio frequency signal. The hybrid combiner includes an output port and an isolation port. The adjustable termination impedance circuit is electrically connected to the isolation port. The adjustable termination impedance circuit is configured to provide different terminations to the isolation port in at least three different modes of the power amplifier system.

The three different modes can include a Doherty mode, a balanced mode, and another mode.

The adjustable termination impedance circuit can be adjusted based on an indication of a reflected power change. The power amplifier system can be configured to operate in the three different modes in different respective load voltage standing wave ratio variation ranges.

Another aspect of this disclosure is a method of multi-mode radio frequency signal amplification. The method includes amplifying a radio frequency signal with a power amplifier circuit in a segmented mode, the segmented mode being different than both Doherty mode and balanced mode, the power amplifier circuit including a first power amplifier core, a second power amplifier core, an output combiner configured to combine output signals from the first and second power amplifier cores, and an adjustable termination impedance circuit connected to a port of the output combiner; adjusting a termination impedance provided by the adjustable termination impedance circuit for a different mode relative to the segmented mode; and amplifying the radio frequency signal in the different mode.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

Embodiments of this disclosure will be described, by way of non-limiting example, with reference to the accompanying drawings.
Figure 1 is a schematic diagram of a radio frequency system with a phased antenna array according to an embodiment.
Figure 2 is a graph of power added efficiency (PAE) versus output power for a Doherty power amplifier for different voltage standing wave ratios (VSWRs) compared to a normalized ideal Class B power amplifier.
Figure 3A is a schematic diagram of a multi-mode power amplifier circuit according to an embodiment.
Figure 3B is a schematic diagram of an example input matching circuit of the multi-mode power amplifier circuit of Figure 3A according to an embodiment.
Figure 3C is a schematic diagram of an example linearization and adaptive bias circuit of the multi-mode power amplifier circuit of Figure 3A according to an embodiment.
Figure 3D is a schematic diagram of example hybrid combiners for multi-mode power amplifier circuit of Figure 3A according to embodiments.
Figure 3E is a schematic diagram of an example switchable termination impedance circuit of the multi-mode power amplifier circuit of Figure 3A according to an embodiment.
Figure 4 is a schematic diagram of a multi-mode power amplifier circuit with power detection and control circuitry according to an embodiment.
Figure 5 is a Smith chart associated with power amplifier load impedance having different VSWRs indicating different modes of operation for a multi-mode power amplifier for different VSWR ranges.
Figure 6A is a schematic diagram of a power amplifier system with an antenna array that performs beam scanning according to an embodiment. Figure 6B is a table summarizing example control bits for beam positions according to an embodiment.
Figure 7 is a schematic diagram of a power amplifier circuit of Figure 3A in Doherty mode according to an embodiment.
Figure 8A is a Smith chart corresponding to the power amplifier circuit of Figure 7. Figure 8B is a graph of gain versus output power for the power amplifier circuit of Figure 7. Figure 8C is a graph of PAE versus output power for the power amplifier circuit of Figure 7.
Figure 9A is a schematic diagram of a power amplifier circuit of Figure 3A in segmented mode according to an embodiment. Figure 9B is a graph of bias voltage versus output power for power amplifier segments of the power amplifier circuit of Figure 9A. Figure 9C is a graph of RF power versus output power for power amplifier segments of the power amplifier circuit of Figure 9A.
Figure 10A is a Smith chart corresponding to the power amplifier circuit of Figure 9A. Figure 10B is a graph of gain versus output power for the power amplifier circuit of Figure 9A. Figure 10C is a graph of PAE versus output power for the power amplifier circuit of Figure 9A.
Figure 11 is a schematic diagram of a power amplifier circuit of Figure 3A in balanced mode according to an embodiment.
Figure 12A is a Smith chart corresponding to the power amplifier circuit of Figure 11. Figure 12B is a graph of gain versus output power for the power amplifier circuit of Figure 11. Figure 12C is a graph of PAE versus output power for the power amplifier circuit of Figure 11.
Figure 13A is a graph of gain versus output power for the power amplifier circuit of Figure 3A for Doherty mode, segmented mode, and balanced mode. Figure 13B is a graph of PAE versus output power for the power amplifier circuit of Figure 3A for Doherty mode, segmented mode, and balanced mode.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings.

Power amplifiers are significant components of wireless transmitters. Power amplifiers can have a significant contribution to overall system efficiency, linearity, and/or output power. A power amplifier can drive an individual antenna element of a phased antenna array in certain applications.

High back-off efficiency can be achieved using various power amplifier (PA) architectures such as Doherty, out phasing PA, or segmented PA. These high efficiency designs are desired for modern communication systems to reduce the system power consumption, reduced cooling costs, and/or save battery life. Such power amplifier architectures can employ load modulation techniques to improve power amplifiers back-off efficiency. These power amplifier architectures can be designed and/or optimized to operate with a specific optimum load impedance, which is typically 50 Ohms.

There can be a voltage standing wave ratio (VSWR) variation due to antenna element coupling shifting power amplifier load impedance away from an optimal value. This VSWR variation can significantly degrade power amplifier performance in a power amplifier system. For example, VSWR variation can degrade one or more of efficiency, linearity, or output power absent compensation. PAs that employ load modulation techniques can be more sensitive to load impedance variations than other PAs.

This disclosure provides technical solutions to improve performance for power amplifier systems as load impedance varies. For example, this disclosure provides technical solutions to improve VSWR variation sensitivity and achieve high efficiency by operating a multi-mode power amplifier circuit in different modes for different VSWR ranges and/or for different beam positions. Such a multi-mode power amplifier circuit can be implemented in millimeter wave (mm-wave) beamformers for fifth generation (5G) and/or sixth generation (6G) wireless communication technology.

Aspects of this disclosure relate to multi-mode power amplifier circuits where the power amplifier operates in different modes for different load impedances. A multi-mode power amplifier circuit can operate in different modes for different VSWR variations and/or different beam angles associated with beam steering. For multiple-input multiple-output (MIMO) and massive MIMO systems, a multi-mode PA can be used to improve the PA sensitivity to VSWR variations, where the VSWR of the PA can change due to limited isolation between neighboring/adjacent channels within the MIMO system. A multi-mode power amplifier circuit can include power amplifier cores, an output combiner (e.g., a hybrid combiner), and an adjustable termination circuit. The output combiner can combine output signals from the power amplifier cores. The adjustable termination circuit can provide different terminations to the output combiner for different modes of operation. The different modes of operation can include a segmented power amplifier mode and at least one other mode of operation. The at least one other mode of operation can include a Doherty mode and/or a balanced mode and/or at least one of Class A mode, a Class B mode, a Class AB mode, a Class C mode, or a Class F mode PA. The muti-mode power amplifier circuit can adjust one or more of a power amplifier bias signal, adaptive bias signal, an input matching network, or an output matching network.

Multi-core power amplifiers can achieve high efficiency and linearity. An example multi-core power amplifier is disclosed in U.S. Patent Publication No. 2022/0094306, the disclosure of which is hereby incorporated by reference in its entirety and for all purposes. Multi-core power amplifiers can be implemented in 5G and/or sixth generation (6G) phased antenna array systems and applications, for example. High efficiency and low VSWR sensitivity in such systems and applications can be achieved with technical solutions disclosed herein.

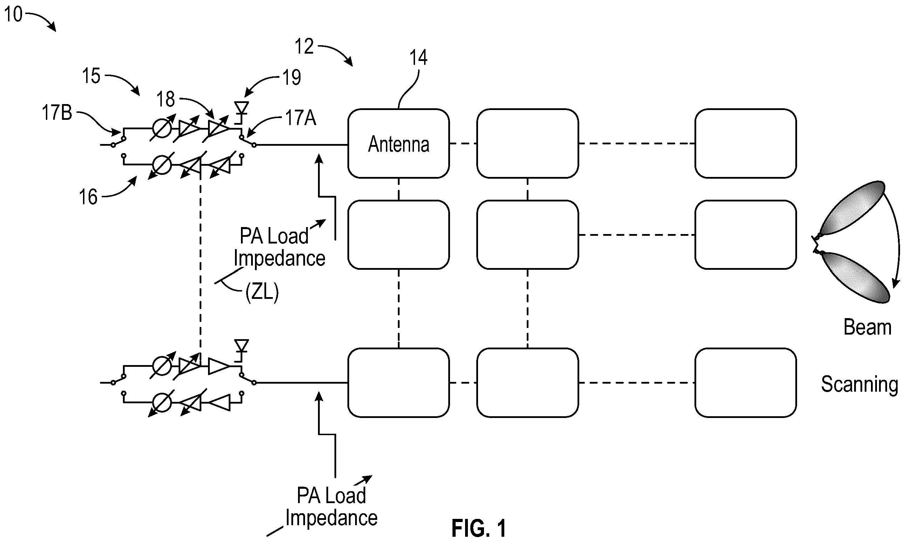

Power amplifiers can drive antenna arrays for beamforming applications. Such power amplifiers can be included, for example, in a cellular base station, an access point, a repeater, a relay, another network node, a router, a user equipment, or the like. An example radio frequency system with an antenna array and power amplifiers will be discussed with reference to Figure 1.

Figure 1 is a schematic diagram of a radio frequency system 10 with a phased antenna array 12 according to an embodiment. The radio frequency system 10 can be included in a network node, such as a cellular base station, in certain applications. The phased antenna array 12 includes an array of antenna elements 14. The radio frequency system 10 includes a plurality of processing channels each associated with a respective antenna element 14. The processing channels can each include a transmit path 15 and a receive path 16. Switches 17A and 17B can selectively electrically couple the transmit path 15 or the receive path 16 to an antenna element 14 and a transceiver (not shown in Figure 1). Each transmit path 15 includes a power amplifier 18. The radio frequency system 10 can use the antenna elements 14 to perform beam scanning.

The antenna elements 14 are driven by the power amplifiers 18 in the transmit paths 15. In certain applications, the power amplifiers 18 can include multi-mode power amplifier circuits in accordance with any suitable principles and advantages disclosed herein. As the radio frequency system 10 preforms beam scanning, the impedance of an antenna element 14 can vary. This impedance variation can be due to coupling with other antenna elements 14 in the phased antenna array 12. Power detection circuitry 19 for a transmit path can detect an indication of reflected power, such as VSWR. This indication of reflected power can be indicative of impedance of an antenna element 14. The power detection circuitry 19 can include a radio frequency coupler and a power detector.

In the radio frequency system 10 of Figure 1, there can be 2:1 or 3:1 VSWR variation even for well-designed relatively low-coupling antenna arrays. Under small beam scanning angles, the antenna impedance can have a VSWR variation of up to 2:1. With larger beam scanning angles, VSWR variation can be up to 3: 1 or even 4: 1. The VSWR variation due to antenna element coupling can shift power amplifier load impedance (ZL) away from its optimal value. This can significantly degrade one or more of the efficiency, output power, gain, and linearity of the power amplifier. As discussed above, high back-off efficiency power amplifiers, such as Doherty power amplifiers, that employ load modulation techniques can be more sensitive to load impedance variations than certain other power amplifiers.

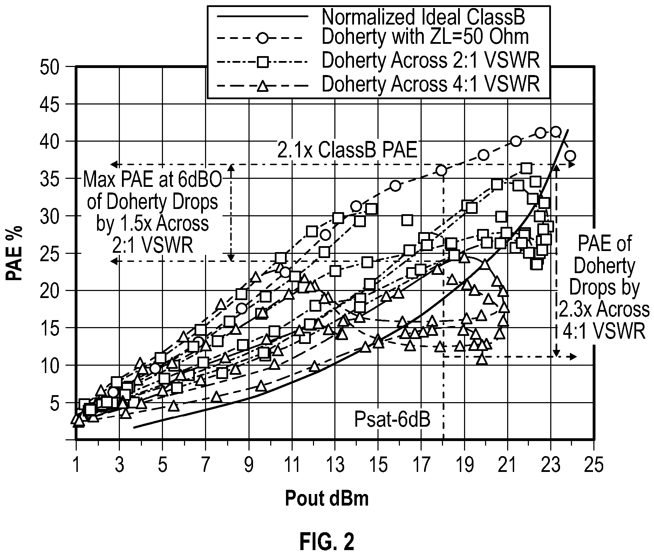

Figure 2 is a graph of power added efficiency (PAE) versus output power for a Doherty power amplifier for different VSWR variations compared to a normalized ideal Class B power amplifier. Figure 2 indicates that for a Doherty power amplifier with a 50 Ohm optimum load impedance, the PAE at 6 dB back-off is greater than 2.1 times the ideal Class B power amplifier PAE. However, with 2:1 VSWR variation, the PAE at 6 dB back-off of the Doherty power amplifier drops to be greater than 1.2 times the ideal Class B power amplifier PAE. With a 4:1 VSWR variation, the Doherty power amplifier 6 dB back-off PAE becomes 0.8 times worse than an ideal Class B power amplifier efficiency. The graphs in Figure 2 indicate that a Doherty power amplifier has desirable PAE under a load impedance that is at or close to an optimum load impedance.

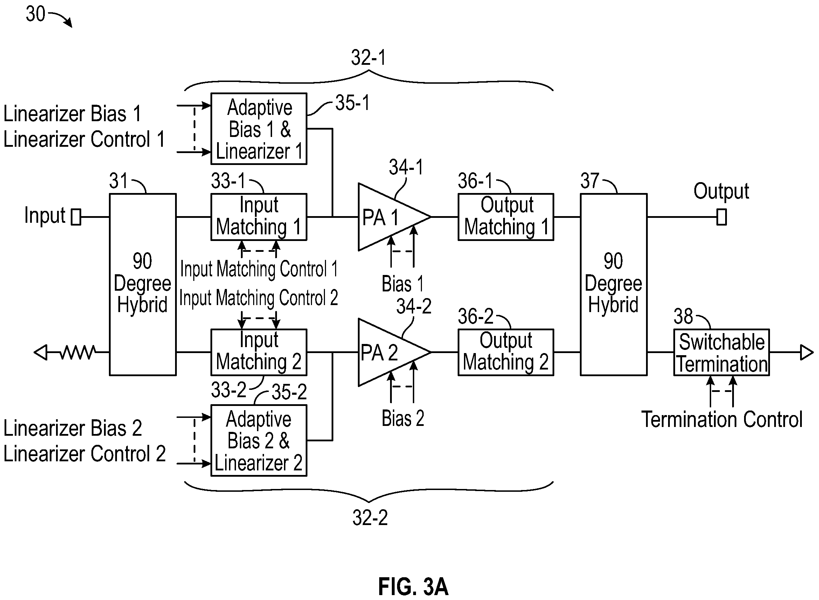

Figure 3A is a schematic diagram of a multi-mode power amplifier circuit 30 according to an embodiment. The multi-mode power amplifier circuit 30 can be included in a power amplifier system that also includes antennas. Such a power amplifier system can be referred to as a multi-mode power amplifier system. The multi-mode power amplifier circuit 30 supports multiple modes of operation across one or more of beam scanning, load impedance variations, or load VSWR variations. The multiple modes can include at least three modes in certain applications. The multiple modes can include any suitable mode including, but not limited to, Doherty mode, segmented mode, and balanced mode. To operate the multi-mode power amplifier circuit 30 in different modes, termination impedance and power amplifier biasing can be adjusted. In addition, impedance(s) of one or more matching circuits can be adjusted for different modes.

In certain embodiments, the multi-mode power amplifier circuit 30 is operable in three modes: Doherty mode, segmented mode, and balanced mode. Doherty mode can be used for bore-side operation and/or a typical load impedance environment. In Doherty mode, the multi-mode power amplifier circuit 30 can support high power amplifier output power Pout and best back-off efficiency operation. The Doherty mode can be used for a first range of VSWR variations. For instance, the Doherty mode can be used for up to 1.2:1 VSWR variations. The Doherty mode can be used for a second range of VSWR variations, where the second range is above the first range and below a third range for balanced mode. The segmented mode can be used for relatively small beam scanning angles and/or moderate load impedance variations, such as variations up to 2:1 VSWR. Segmented mode can be used for larger load impedance variations than Doherty mode operation. In the segmented mode, the multi-mode power amplifier circuit 30 can achieve target power amplifier output power Pout with at least moderate efficiency operation. The multi-mode power amplifier circuit 30 in segmented mode can achieve better efficiency, output power when the power amplifier is saturated (Psat), and 1 decibel compression point (P1dB) than the Doherty mode for 2:1 VSWR variations. The balanced mode can involve adaptive power amplifier biasing for relatively large beam scanning angles and/or relatively large load impedance variations, such as greater than 2:1 VSWR variations. In the balanced mode, the multi-mode power amplifier circuit 30 can achieve Psat close to a target, P1dB near a target, and PAE better than for the Doherty mode or the segmented mode under high VSWR variations, such greater than 2:1 VSWR variations.

As illustrated, the multi-mode power amplifier circuit 30 includes a hybrid input splitter 31, a first power amplifier segment 32-1, a second power amplifier segment 32-2, a hybrid output combiner 37, and an adjustable termination impedance circuit 38. The hybrid input splitter 31 is a hybrid coupler. The hybrid input splitter 31 is an example of an input splitter that can split a radio frequency (RF) input signal into signal components for the first power amplifier segment 32-1 and the second power amplifier segment 32-2. The hybrid input splitter 31 can provide two split radio frequency signals with a certain degree phase shift relative to each other. For instance, the hybrid input splitter 31 can split provide two split radio frequency signals with a phase relative to each other in a range from 60 degrees to 130 degrees. In certain applications, the hybrid input splitter 31 can split provide two split radio frequency signals with a 90 degree phase relative to each other. The input signal to the second power amplifier segment 32-2 can be phase shifted 90 degrees relative to the input signal to the first power amplifier segment 32-1. The hybrid input splitter 31 can divide the power of the RF input signal to determine the relative amplitudes of the input signal to the first power amplifier segment 32-1 and the input signal to the second power amplifier segment 32-2.

As shown in Figure 3A, the first power amplifier segment 32-1 includes a first input matching network 33-1 connected to the hybrid input splitter 31, a first power amplifier core 34-1, a first adaptive bias and linearization circuit 35-1 to generate a bias signal for the first power amplifier core 34-1, and a first output matching network 36-1. The second power amplifier segment 32-2 includes a second input matching network 33-2 connected to the hybrid input splitter 31, a second power amplifier core 34-2, a second adaptive bias and linearization circuit 35-2 to generate a bias signal for the second power amplifier core 34-1, and a second output matching network 36-2.

A radio frequency (RF) input signal at an input node Input can be split by the hybrid input splitter 31 to a first signal for the first power amplifier segment 32-1 and a second signal the second power amplifier segment 32-2. The first input matching network 33-1 can perform input matching for the first power amplifier core 34-1. The second input matching network 33-2 can perform input matching for the second power amplifier core 34-2. The first input matching network 33-1 and the second input matching network 33-2 can each be programmable. The first input matching network 33-1 and the second input matching network 33-2 can each include a controllable (e.g., switchable) passive component. The first input matching network 33-1 and/or the second input matching network 33-2 can be adjusted based on an indication of a reflected power change or load VSWR change. Impedances of the input matching networks 33-1 and 33-2 can impact and/or control a power splitting ratio between radio frequency input signals provided to power amplifier cores 34-1 and 34-2. The input matching networks 33-1 and/or 33-2 can be controlled to provide a phase shift between an input signal for the first power amplifier core 34-1 and the second power amplifier core 34-2 to increase and/or maximize the combined output signal after the hybrid output combiner 37.

The first signal can be amplified by the first power amplifier core 34-1. Similarly, the second signal can be amplified by the second power amplifier core 34-2. The power amplifiers cores 34-1 and 34-2 can have any suitable power amplifier topology. The power amplifiers cores 34-1 and 34-2 can include any suitable power amplifier transistors, such as, but not limited to, field effect transistors (FETs) (e.g., metal oxide semiconductor FETs (MOSFETs), p type FETs (PFETs), n type FETs (NFETs), or pseudomorphic high electron mobility transistors (pHEMTs)) and/or bipolar transistors. In certain applications, the first power amplifier core 34-1 can have a different number of power amplifier transistors and/or power amplifier transistor area/size than the second power amplifier core 34-2. The supply voltage of first power amplifier core 34-1 can be different than the supply voltage for the second power amplifier core 34-2.

The first adaptive bias and linearization circuit 35-1 provides a first bias signal to an input of the first power amplifier core 34-1. The first bias signal can be adjusted for different modes of operation of the first power amplifier core 34-1. The first adaptive bias and linearization circuit 35-1 can adaptively adjust the first bias signal during a mode of operation. The second adaptive bias and linearization circuit 35-2 provides a second bias signal to an input of the second power amplifier core 34-2. The second bias signal can be adjusted for different modes of operation of the second power amplifier core 34-2. The second adaptive bias and linearization circuit 35-2 can adaptively adjust the second bias signal during a mode of operation.

The first output matching network 36-1 can perform output matching for the first power amplifier core 34-1. The second output matching network 36-2 can perform output matching for the second power amplifier core 34-2. The first output matching network 36-1 and/or the second output matching network 36-2 can be programmable. The output matching networks 36-1 and/or 36-2 can be adjusted for different modes of operation of the multi-mode power amplifier circuit 30. In certain applications, the output matching networks 36-1 and 36-2 can each include one or more switches for adjusting the output matching impedance for different modes of operation. For instance, the output matching networks 36-1 and/or 36-2 can include one or more shunt capacitors that are each in series with a respective switch.

Output signals from the output matching networks 36-1 and 36-2 can be combined with the hybrid output combiner 37 to generate a combined power amplifier output signal. The hybrid output combiner 37 is an example of an output combiner that can combine RF signals from the first power amplifier core 34-1 and the second power amplifier core 34-2. One of the output signals can be phase shifted by a certain amount relative to the other output signal by the hybrid output combiner 37. This can undo the phase shift from the hybrid input splitter 31. The hybrid output combiner 37 can phase shift one of the output signals by an amount in a range from 60 degrees to 130 degrees relative to the other output signal. In certain applications, the hybrid output combiner 37 can phase shift one of the output signals by 90 degrees relative to the other output signal. With the phase shift by the hybrid output combiner 37, radio frequency signals from the different power amplifier cores 34-1 and 34-2 can be in phase with each other. The adjustable termination impedance circuit 38 can adjust a termination impedance at a port of the hybrid output combiner 38. The adjustable termination impedance circuit 38 can provide different terminations for different modes of operation.

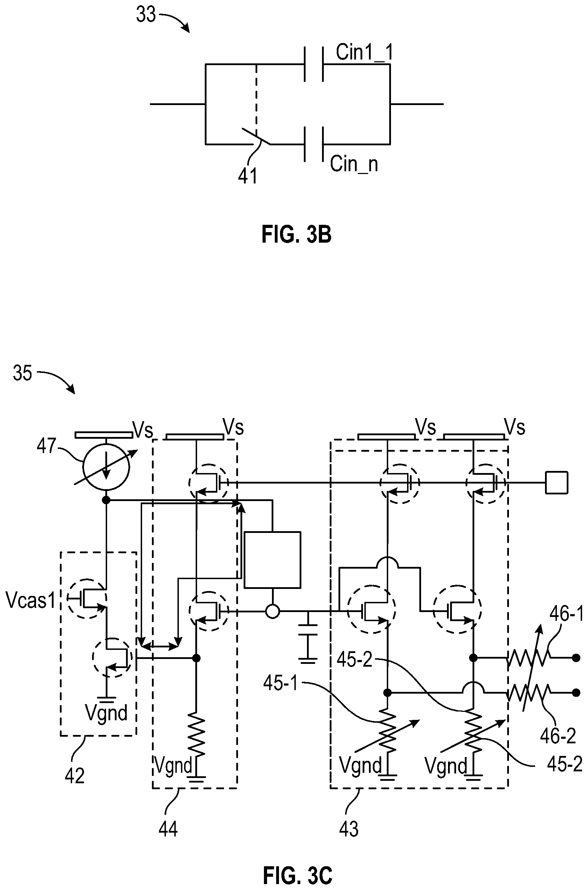

Figure 3B is a schematic diagram of an example input matching network 33 according to an embodiment. The example input matching network 33 can implement the first input matching network 33-1 and/or the second input matching network 33-2 of the multi-mode power amplifier circuit 30 of Figure 3A. The input matching network 33 can be in different states in different power amplifier segments 32-1 and 32-2. The input matching network 33 can be used control and/or adjust a power splitting ratio between the power amplifier cores 34-1 and 34-2 in the multi-mode power amplifier circuit 30.

As illustrated in Figure 3B, the input matching network 33 can include a capacitor Cin1_1 and one or more switched capacitors Cin_n that are in series with a respective switch 41. Each switched capacitor of the input matching circuit 33 can be electrically coupled or electrically isolated from a node (e.g., an output of the hybrid input splitter 31 or an input to a power amplifier core) using a respective switch 41. Programmability can be achieved in the matching network 33 using one or more digital control bits. The one or more digital control bits can select which switched capacitors to switch in and to switch out. The input matching network 33 can be used control and/or adjust a power splitting ratio between the power amplifier cores 34-1 and 34-2 in the multi-mode power amplifier circuit 30. Any other suitable adjustable input matching networks can alternatively or additionally be implemented.

Figure 3C is a schematic diagram of an example linearization and adaptive bias circuit 35 of the multi-mode power amplifier circuit 30 of Figure 3A according to an embodiment. The linearization and adaptive bias circuit 35 is an example of the first linearization and adaptive bias circuit 35-1 of Figure 3A. The linearization and adaptive bias circuit 35 can alternatively or additionally implement the second linearization and adaptive bias circuit 35-2 of Figure 3A. The linearization and adaptive bias circuit 35 can function as described in U.S. Patent Publication No. 2022/0094306, which is hereby incorporated by reference in its entirety and for all purposes. The linearization and adaptive bias circuit 35 can generate an adaptive power amplifier bias signal that changes as a function of input power. The adaptive power amplifier bias signal can be a voltage or a current. The linearization and adaptive bias circuit 35 can also generate a non-direct current signal component to cancel power amplifier non-linearities to improve overall linearity. Such a non-direct current signal component has a non-zero frequency. The linearization and adaptive bias circuit 35 can generate a bias signal for a power amplifier core that includes a direct current bias component and at least one non- direct current radio frequency tone in the segmented mode. This can improve overall linearity. A magnitude of direct current bias component and a magnitude of the non- direct current radio frequency tone can be adjusted by the linearization and adaptive bias circuit 35 based on an indication of a reflected power change.

As illustrated, the linearization and adaptive bias circuit 35 includes a bias circuit 42, a linearization circuit 43, and a linearizer coupling circuit 44. The linearization and adaptive bias circuit 35 includes a feedback path coupling an output of the linearizer coupling circuit 44 to the input of the bias circuit 42, thus forming a biasing loop. The linearization circuit 43 an include adjustable resistors 45-1 and 45-2. The adjustable resistors 45-1 and/or 45-2 can be programmed to adjust the linearization circuit 43. In some instances, the adjustable resistors 45-1 and/or 45-2 can be replaced by current source(s). A coupling circuit including adjustable resistors 46-1 and/or 46-2 that can be programmed to adjust the coupling circuit. An adjustable current source 47 can generate a signal for the bias circuit 42.

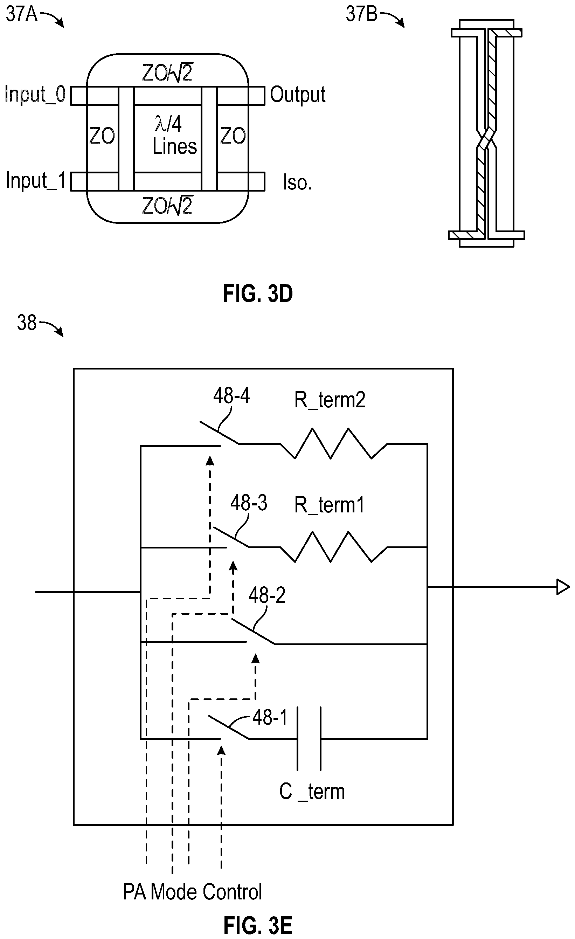

Figure 3D is a schematic diagram of example hybrid combiners 37A and 37B that can be implemented in the multi-mode power amplifier circuit 30 of Figure 3A according to embodiments. The hybrid combiner 37 of Figure 3A can be implemented by the hybrid combiner 37A or the hybrid combiner 37B. The hybrid output combiner 37 of Figure 3A can be implemented by any suitable 90 degree hybrid combiner or any other suitable passive combiner that combines at least two signal with un-equal phases. For example, a hybrid combiner 37A with lumped inductance and capacitance can be implemented. As another example, a hybrid combiner 38B with coupled transmission lines can be implemented. Any other suitable hybrid combiner for coupling signals with 90 degree phase difference can be implemented for the hybrid combiner 37. For instance, a hybrid combiner can include a Wilkinson combiner with a quarter wavelength transmission line at one of two inputs. In certain applications, a hybrid combiner can implement a phase shift that is approximately 90 degrees. In some applications, a hybrid combiner can be implemented a phase shift in a range from 60 degrees to 130 degrees and achieve suitable performance. The hybrid input splitter 31 of Figure 3A can be implemented with a structure similar to any of the hybrid combiners disclosed herein and arranged to split an input radio frequency signal. Such a hybrid combiner can be arranged as a splitter instead of a combiner, for example, as shown in Figure 3A.

Figure 3E is a schematic diagram of an example adjustable termination impedance circuit 38 of the multi-mode power amplifier circuit 30 of Figure 3A according to an embodiment. The adjustable termination impedance circuit 38 can provide a plurality of different termination impedances to the isolation port of the hybrid output combiner 37 of Figure 3E. The isolation port of the hybrid output combiner 37 of Figure 3A can be referred to a termination port. The adjustable termination impedance circuit 38 can provide different terminations for different modes of operation of the multi-mode power amplifier circuit 30. In different states, the adjustable termination impedance circuit 38 can selected one or more termination impedances to provide to a port of the output hybrid combiner 37 of Figure 3A.

The adjustable termination impedance circuit 38 can provide a variety of different termination impedances, such as but not limited to a short circuit impedance (low impedance), an open circuit impedance (high impedance), one or more resistive impedances such as a resistive impedance in a range from 25 Ohm to 100 Ohm, one or more capacitive impedances, a combination of one or more resistive impedances and one or more capacitive impedances, or the like. One or more of the termination impedances can be selected for each mode of operation based on a power amplifier mode control signal PA Mode Control. As shown in Figure 3E, switches 48-1, 48-2, 48-3, and 48-4, can select respective termination impedances. For example, switch 48-1 can select a capacitive termination impedance C_term, switch 48-2 can select a short circuit termination impedance, switch 48-3 can select a first resistive termination impedance R_term1, and switch 48-4 can select a second resistive termination impedance R_term2. Any other suitable termination impedances and/or ways to adjust a termination impedance can alternatively or additionally be implemented.

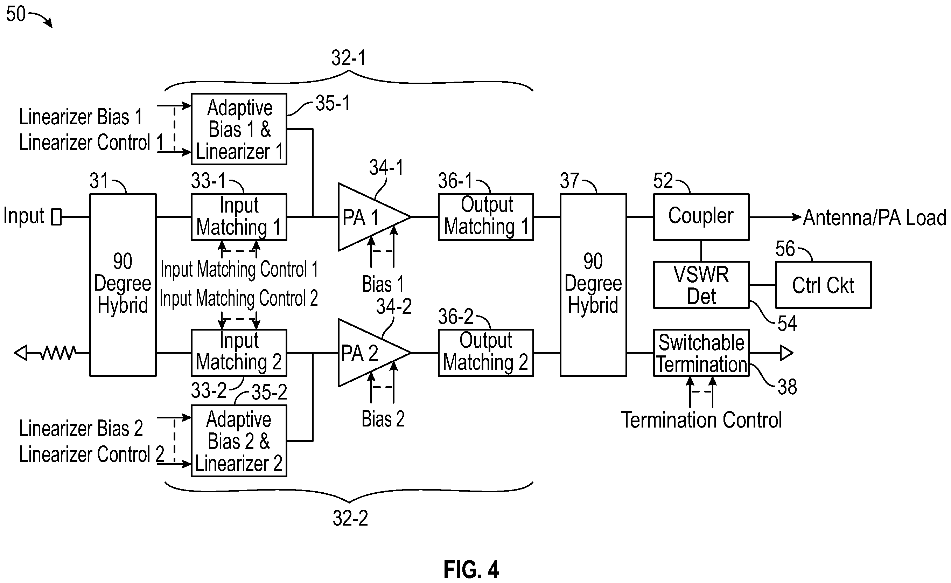

Figure 4 is a schematic diagram of a multi-mode power amplifier circuit 50 with power detection and control circuitry according to an embodiment. The multi-mode power amplifier circuit 50 can detect an indication of VSWR and set a mode of operation based on the indication of VSWR. The multi-mode power amplifier circuit 50 includes the circuitry of the multi-mode power amplifier circuit 30 of Figure 3A and circuitry for detecting VSWR and controlling the mode of operation of the multi-mode power amplifier circuit 30. As illustrated, the multi-mode power amplifier circuit 50 includes a radio frequency coupler 52, a VSWR detector 54, and a control circuit 56.

The radio frequency coupler 52 can couple a portion of radio frequency power propagating between the hybrid output combiner 37 and an antenna (or other power amplifier load). The portion of radio frequency power can be provided to the VSWR detector 54. The VSWR detector 54 can detect an indication of power amplifier load impedance, such as an indication of an impedance value or impedance area associated with a group of impedance values.

The control circuit 56 can receive an output signal from the VSWR detector 54. The control circuit 56 can set a mode of operation for the power amplifier circuit 50 based on the indication of power amplifier load impedance from the VSWR detector 54. Each impedance region can correspond to a set of power amplifier control bits to set the power amplifier operating mode that corresponds to the detected VSWR ratio region.

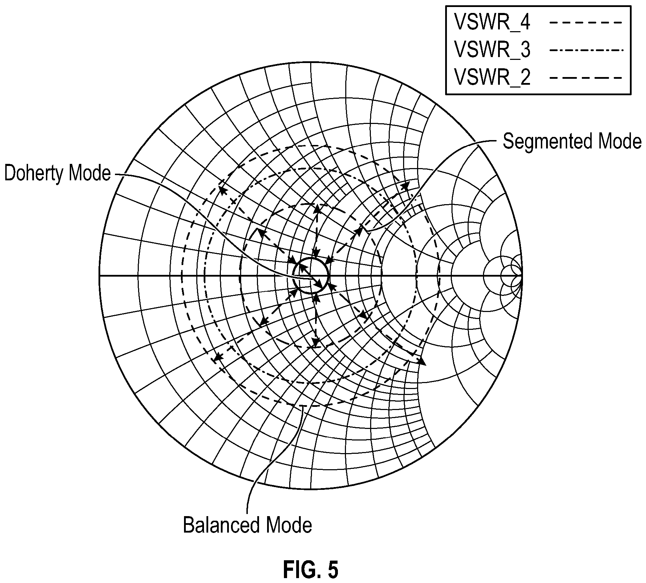

Figure 5 is a Smith chart associated with power amplifier load impedance having different VSWRs indicating different modes of operation for the power amplifier circuit 50 for different VSWR ranges. Within an inner circle in the Smith chart of Figure 5 at VSWR of 1.2, the power amplifier circuit 50 can operate in Doherty mode. Accordingly, Doherty mode can be used for VSWR in a range from 1 to 1.2. The next circle away from the center point in Figure 5 is at VSWR of 2. The power amplifier circuit 50 can operate in segmented mode for VSWR in a region between the inner circle and the next outward circle. Accordingly, segmented mode can be used for VSWR in a range from 1.2 to 2. Outside of the circle for VSWR of 2, the power amplifier circuit 50 can operate in balanced mode. The power amplifier circuit 50 can operate in balanced mode for VSWR in a range from 2 to 4, for example.

Referring to Figure 4, the set of power amplifier control bits for each mode of operation can be stored in any suitable memory, such as a look up table (LUT), non-volatile memory, or any other suitable storage unit. Such a memory can be included in the control circuit 56. Table 1 below summarizes example control bits for the different modes of operations, which correspond to different detected VSWR impedances. The detected VSWR in Table 1 corresponds to the indication of power amplifier load impedance from the VSWR detector 54. The PA 1 control bits in Table 1 can include input matching control bits for the first input matching network 33-1, linearization bias and/or control bits for the first linearization and adaptive bias circuit 35-1, and bias bits for the first power amplifier core 34-1. In some instances, the PA 1 control bits can include one or more control bits for the first output matching network 36-1. The PA 2 control bits in Table 1 can include input matching control bits for the second input matching network 33-2, linearization bias and/or control bits for the second linearization and adaptive bias circuit 35-2, and bias bits for the second power amplifier core 34-2. In some instances, the PA 2 control bits can include one or more control bits for the second output matching network 36-2. The termination control in Table 1 can select a termination for the adjustable termination impedance circuit 38. The control circuit 56 can set the mode of operation for the power amplifier circuit 50 for a standalone power amplifier and/or for a power amplifier in a beamforming system.

**Table 1**

| **Mode** | **VSWR Detected** | **PA1 Control Bits** | **PA2 Control Bits** | **Termination Control** |
|---|---|---|---|---|
| Doherty | Within 1.2:1 VSWR region | Doherty control settings applied | Doherty control settings applied | Short circuit or capacitor termination ON |
| Segmented | Within 2:1 VSWR region and outside of 1.2:1 VSWR region | Segmented control settings applied | Segmented control settings applied | Resistor or capacitor termination ON |
| Balanced | Outside of 2:1 VSWR region | Balanced control settings applied | Balanced control settings applied | Resistor termination ON |

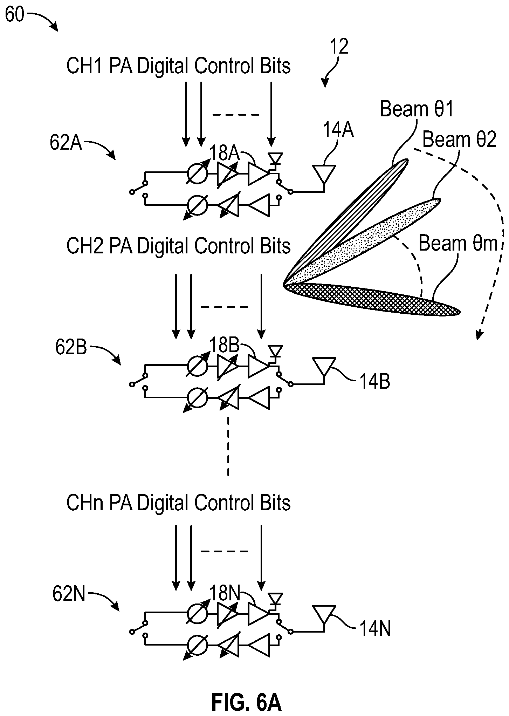

Figure 6A is a schematic diagram of a power amplifier system 60 with a phased antenna array 12 that performs beam scanning according to an embodiment. The power amplifier system 60 includes antennas 14A to 14N and a plurality of processing channels 62A, 62B, 62N that each include a respective power amplifier 18A, 18B, 18N that drives a respective antenna 14A, 14B, 14N. Each power amplifier 18A, 18B, 18N can include a power amplifier circuit 30 of Figure 3A. The power amplifier system 60 can be used for beamforming. In the power amplifier system 60, the mode of operation can be set based on beam angle. In beamforming systems (e.g., with ≥ 5x5 antenna elements), most (e.g., ≥80%) of channels 62A to 62N can have power amplifier VSWR variations versus beam scanning that are the same or substantially the same.

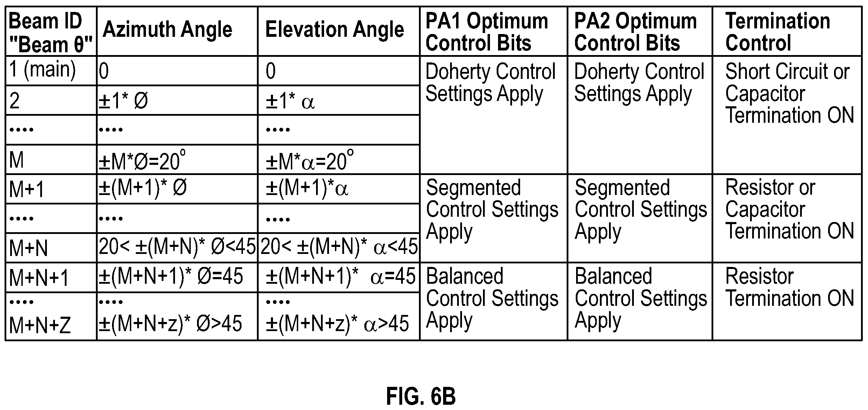

Figure 6B is a table summarizing example control bits for beam positions according to an embodiment. The control bits in this table can be used to control power amplifier circuits of a relatively large array. The control bits can be applied to all power amplifiers of an array that drive an antenna array. The control bits can be applied to any suitable subset of power amplifiers of an array.

In Figure 6B, power amplifier parameters are provided for beam positions where each beam position has an azimuth angle and an elevation angle. The control bits PA1 can control the settings of first power amplifier segment 32-1, the control bits PA2 can control the settings of the second power amplifier segment 32-2, and the termination control can set a state of the adjustable termination impedance circuit 38 of Figure 3A. The control bits for corresponding beam positions can be stored in any suitable memory, such as a LUT, non-volatile memory, or any other suitable storage unit. The control bits can be applied during an initialization sequence in certain applications.

For a bore side "main" beam where both azimuth and elevation angles = 0 and with relatively small beam angles beam scanning up to 20 degrees, for example, Doherty power amplifier mode operation can be enabled by applying Doherty control bits.

At with larger beam scanning angles, for example, in a range from 20 degrees < abs(α, ø) <45 degrees, the segmented power amplifier mode operation mode can be enabled by applying segmented control bits.

With larger beam scanning angles, for example, abs(α, ø) => 45 degrees, a balanced power amplifier operation mode can be enabled by applying balanced control bits.

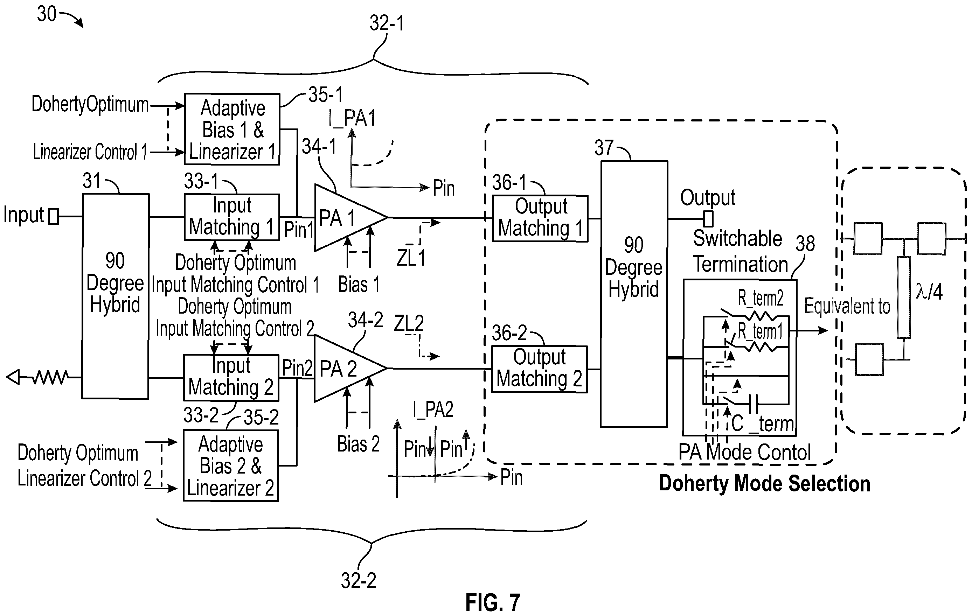

Configurations and performance of the multi-mode power amplifier circuit 30 of Figure 3A for different modes of operation will be discussed with references to Figures 7 to 13B.

Figure 7 is a schematic diagram of a power amplifier circuit 30 of Figure 3A in a Doherty mode operation according to an embodiment. The power amplifier circuit 30 can function as a Doherty power amplifier at and/or near optimum load conditions where high back-off PAE can be achieved. In the Doherty mode, the adjustable termination impedance circuit 38 is in a state that provides a quarter wavelength transmission line behavior between an output of the first power amplifier core 34-1 and an output of the second power amplifier core 34-2. This can provide load modulation at the load of the first power amplifier core 34-1 such that: (1) at low input power the second power amplifier core 34-2 is off and the first power amplifier core 34-1 is loaded with optimum (or near optimum) PAE load impedance; (2) at higher input power, the second power amplifier core 34-2 starts to turn on where the hybrid output combiner 37 is arranged to provide load modulation at the load of the first power amplifier core 34-1 where the load impedance at the first power amplifier core 34-1 moves from an optimum efficiency region to optimum power impedance and the load impedance of the second power amplifier core 34-2 moves toward optimum power impedance; and (3) the hybrid output combiner 37 combines output power Pout1 from the first power amplifier core 34-1 and output power Pout2 from the second power amplifier core 34-2 for maximum (or near maximum) combined output power Pout by cancelling the phase difference of output powers from the first power amplifier core 34-1 and the second power amplifier core 34-2. The adjustable termination impedance circuit 38 can provide a short circuit termination for Doherty mode in certain instances. The adjustable termination impedance circuit 38 can provide a capacitor termination for Doherty mode in some other instances.

The bias signal Bias 1 for the first power amplifier core 34-1 can bias the first power amplifier core 34-1 for Class A, Class B, or Class AB operation in Doherty mode. The bias signal Bias 1 can be a bias voltage or a bias current. The bias signal Bias 2 for the second power amplifier core 34-2 can bias the second power amplifier core 34-2 for Class B or Class C operation in Doherty mode, where the second power amplifier core 34-2 is off at low input power and turns on at higher input power. The bias signal Bias 2 can be a bias voltage or a bias current.

In the Doherty mode, the input matching control bits for the first input matching network 33-1 and the input matching control bits for the second input matching network 33-2 can be set to control the input power level at an input to each power amplifier core 34-1, 34-2 and to compensate for any phase mismatch between power amplifier signals to ensure a total 90 degree phase shift between output signals of the first power amplifier core 34-1 and the second power amplifier core 34-2. This can achieve desirable PAE and combined output power Pout operation in Doherty mode.

The linearization bias and/or control bits for the first linearization and adaptive bias circuit 35-1 and the second linearization and adaptive bias circuit 35-2 can be set and/or optimized to achieve desirable AM to AM and AM to PM.

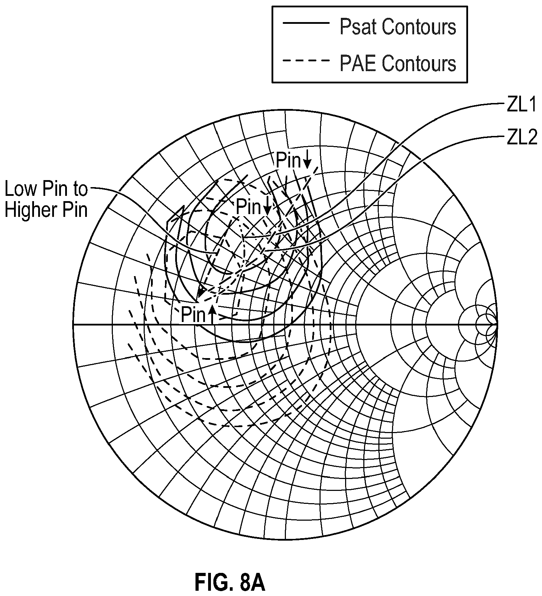

Figure 8A is a Smith chart corresponding to the power amplifier circuit 30 in Doherty mode.

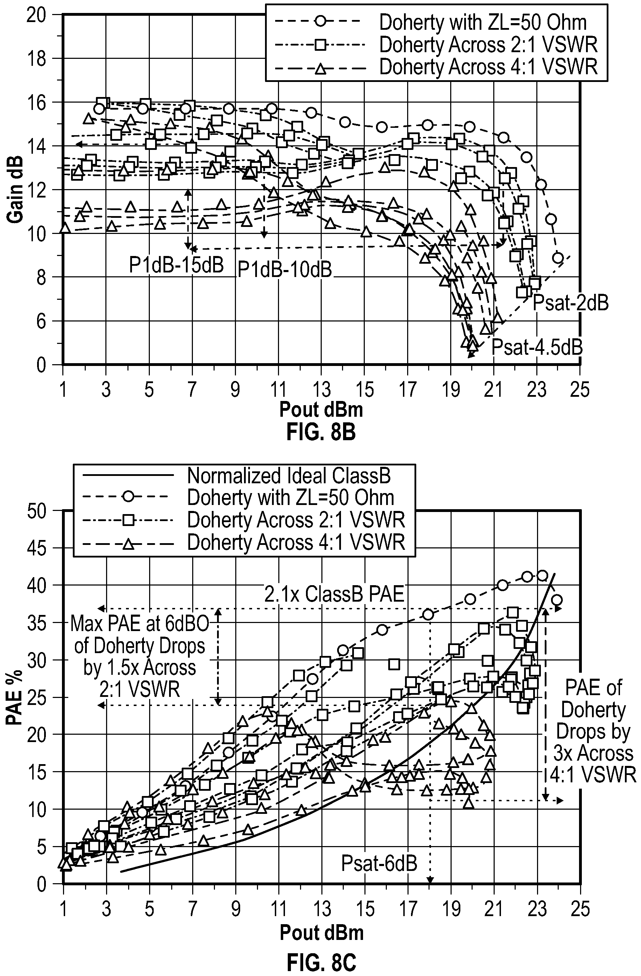

Figure 8B is a graph of gain versus output power for the power amplifier circuit 30 in Doherty mode. Figure 8C is a graph of PAE versus output power for the power amplifier circuit 30 in Doherty mode. In the graphs of Figures 8B and 8C, the power amplifier circuit 30 in Doherty mode is operated under different load conditions. The different load conditions include an optimum load condition where the load impedance is 50 Ohms, 2:1 load VSWR, and 4:1 load VSWR.

The power amplifier circuit 30 in Doherty mode can achieve the best performance at the optimum load condition, with 36.5% PAE at 6 dBO, with 24.5 dBm maximum Psat, and good AM to AM flatness versus output power Pout which can result in a good linearity and relatively easy digital predistortion (DPD). This PAE is greater than 2x the PAE of an ideal Class B power amplifier.

At 2:1 load VSWR for the power amplifier circuit 30 in Doherty mode, the worst backed off PAE drops by about 1.5x from its maximum value with optimum load while achieving 24% PAE. Also, the Psat drops by 2 dB and AM to AM flatness degrades, resulting in 10 dB lower P1dB.

At 4:1 load VSWR for the power amplifier circuit 30 in Doherty mode, the worst backed-off PAE drops by 3x from its maximum value with optimum load achieving 12% PAE, which is lower than an ideal Class B power amplifier with an optimum load. Also, the Psat drops by 4.5 dB from its maximum value and AM to AM flatness degrades significantly, resulting in 15 dB lower P1dB.

The graphs of Figures 8B and 8C indicate that the power amplifier circuit 30 in Doherty mode has relatively high VSWR sensitivity. Accordingly, the power amplifier circuit 30 in Doherty mode can be suitable for optimum and near optimum load operation. The power amplifier circuit 30 can operate in one or more different modes at higher VSWR, such as VSWR that is greater than or equal to 1.2:1 and/or greater than or equal to 2:1.

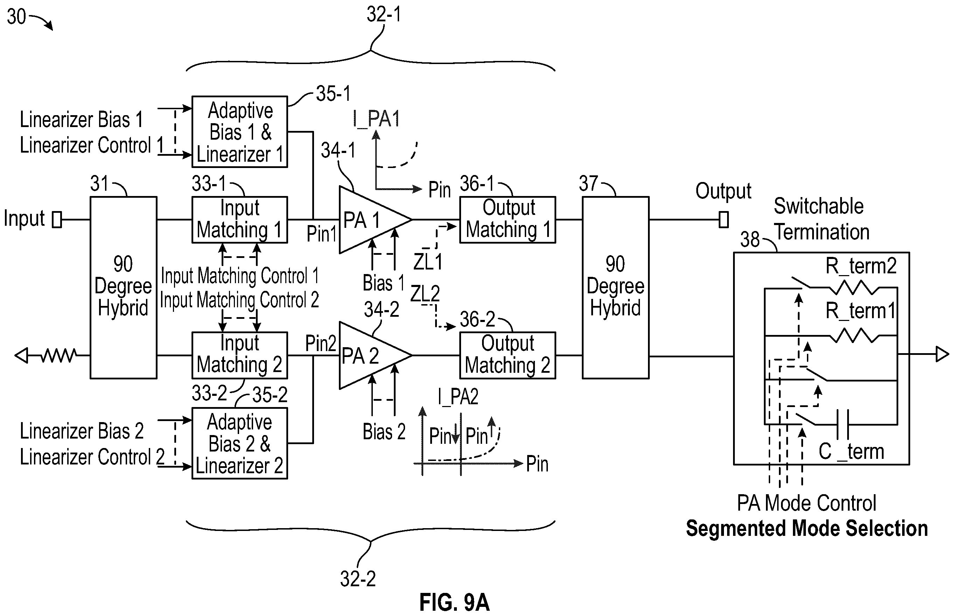

Figure 9A is a schematic diagram of a power amplifier circuit 30 of Figure 3A in segmented mode operation according to an embodiment. The power amplifier circuit 30 can operate in segmented mode with VSWR variations in a range from 1.2: 1 to 2:1 and achieve moderate PAE at the average operating power. The second power amplifier core 34-2 has a greater than zero bias for low input power in segmented mode in contrast to Doherty mode. In the segmented mode, the power amplifier circuit 30 operates differently than in the Doherty mode and in the balanced mode.

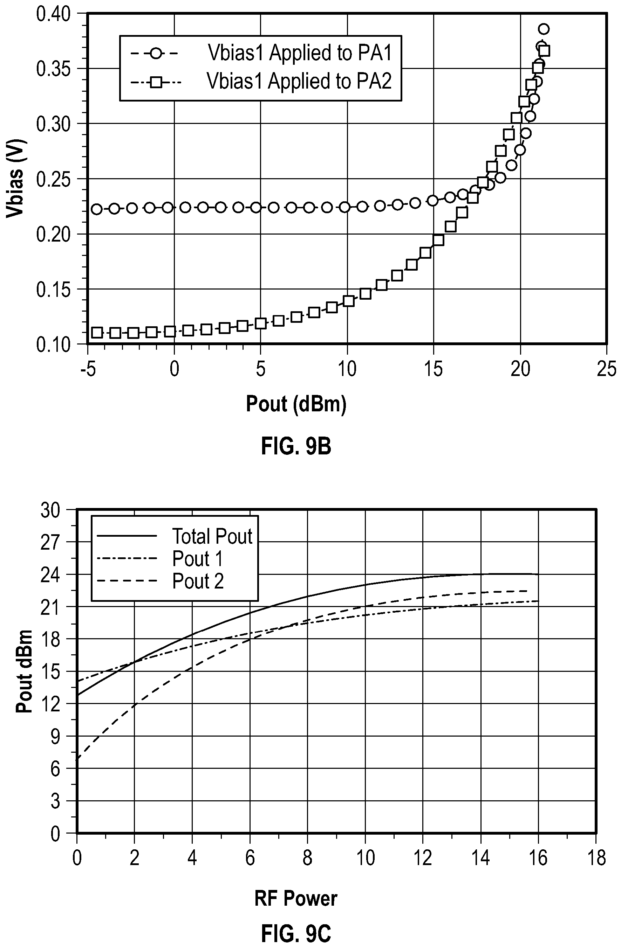

As shown in Figure 9B, a first bias voltage Vbias 1 for the first power amplifier 35-1 can be generated by the first adaptive bias and linearization circuit 35-1 with a moderate linearization device in order to generate such constant first bias voltage Vbias 1 versus input power in the segmented mode. Figure 9B also shows that a second bias voltage Vbias2 for the second power amplifier core 34-2 can be generated from the second adaptive bias and linearization circuit 35-2 using a highly non-linear device to generate the illustrated slope of the second bias voltage Vbias2 versus input power and to cancel the high non-linearities of the second power amplifier core 34-2 operating as a Class B core in the segmented mode.

Referring to Figure 9A, the input matching networks 33-1 and 33-2 can be in a state to split input power without losing 3 dB of gain in the second power amplifier core 34-2 "off-core" in the segmented mode. As the turn on voltage of the second power amplifier core 34-2 depends on its input power Pin and also the second bias voltage Vbias 2from the second adaptive bias and linearization circuit 35-2. The linearizer circuits of the first adaptive bias and linearization circuit 35-1 and the second adaptive bias and linearization circuit 35-2 can be in states to generate a different bias signal at each power amplifier input, where each bias signal has a direct current component that is function of each power amplifier core input power and radio frequency component to cancel each power amplifier core self-nonlinearity to improve the overall linearity of each power amplifier.

In the segmented mode, the adjustable termination impedance circuit 38 can be in a state that (1) together with the first output matching network 36-1 provides an optimum efficiency (or near optimum efficiency) load to the first power amplifier core 34-1 and (2) together with the second output matching network 36-2 provides an optimum power load (or near optimum power load) to the second power amplifier core 34-2 to achieve maximum (or near maximum) output power. The adjustable termination impedance circuit 38 can select a resistor termination R_term1 as a termination impedance for the hybrid output combiner 37 in the segmented mode as illustrated. Alternatively or additionally, the adjustable termination impedance circuit 38 can select a capacitor C_term for providing a termination impedance for the hybrid output combiner 37 in the segmented mode. The resistor termination R_term1 selected in Figure 9A can have a higher impedance than a resistor termination (e.g., resistor termination R_term2) for balanced mode. For example, the resistor termination R_term1 can have a termination impedance of 100 Ohms and the resistor termination R_term2 for balanced mode can have a termination impedance of 50 Ohms.

Figure 9C is a graph of radio frequency power versus output power for power amplifier cores of the power amplifier circuit of Figure 9A. This graph shows the contributions of each power amplifier core to total output power of the power amplifier circuit 30 in the segmented mode for different RF power levels.

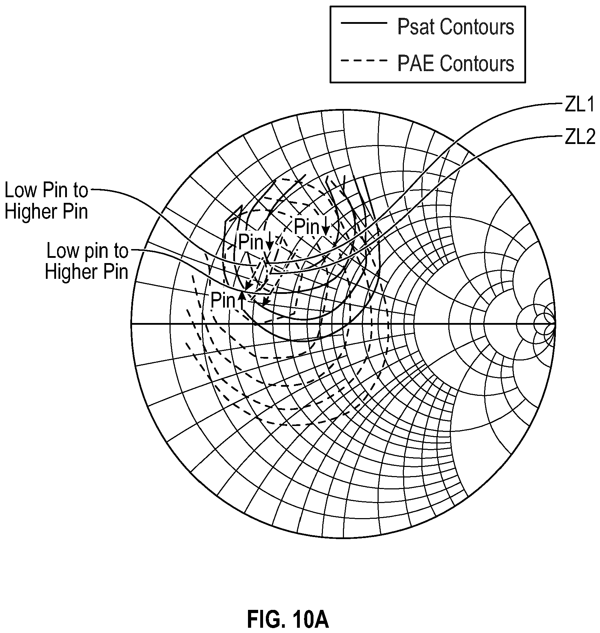

Figure 10A is a Smith chart corresponding to the power amplifier circuit 30 operating in segmented mode.

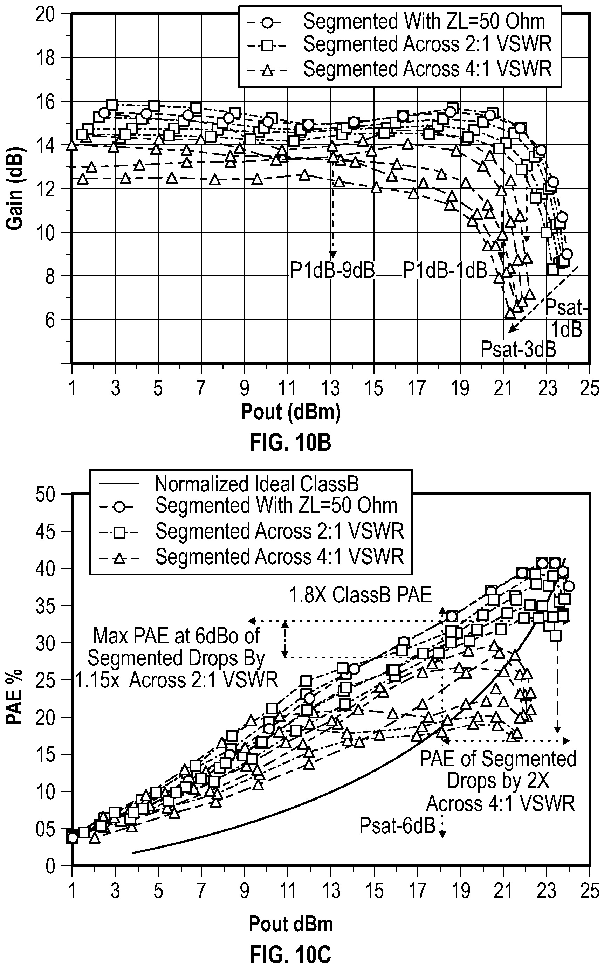

Figure 10B is a graph of gain versus output power for the power amplifier circuit 30 in segmented mode. Figure 10C is a graph of PAE versus output power for the power amplifier circuit 30 in segmented mode. In the graphs of Figures 10B and 10C, performance of the power amplifier circuit 30 in the segmented mode under different load conditions in shown.

With an optimum load condition where the load impedance is 50 Ohms, the power amplifier circuit 30 in segmented mode can achieve its peak performance with 33% PAE at 6 dBO, a 24.5dBm maximum Psat, and desirable AM to AM flatness versus output power Pout, which results in a good linearity and relatively easy DPD. This PAE is greater than 1.8x the PAE of normalized ideal Class B power amplifier.

At 2:1 load VSWR for segmented mode, the worst backed-off PAE drops by about 1.15x from its maximum value with optimum load while achieving 28% PAE. Also, the Psat drops by 1 dB and AM to AM flatness can still achieve good linearity and relatively easy DPD, resulting in 1 dB lower P1dB. At 4:1 load VSWR for segmented mode, the worst backed-off PAE drops by 2x from its maximum value with optimum load while achieving 22% PAE, which is comparable to a Class B power amplifier with optimum load. Also, the Psat drops by 3 dB from its maximum value and AM to AM flatness degrades, resulting in 10 dB lower P1dB.

The graphs of Figures 10B and 10C indicate that the power amplifier circuit 30 in segmented mode has moderate VSWR sensitivity. The power amplifier circuit 30 in segmented mode can be suitable for optimum load operation and for 2:1 VSWR variation operation. The power amplifier circuit 30 can operate in segmented mode for less than or equal to 2:1 VSWR variation. In certain applications, the power amplifier circuit 30 can operate in segmented mode for VSWR variation in a range from 1.2:1 to 2:1.

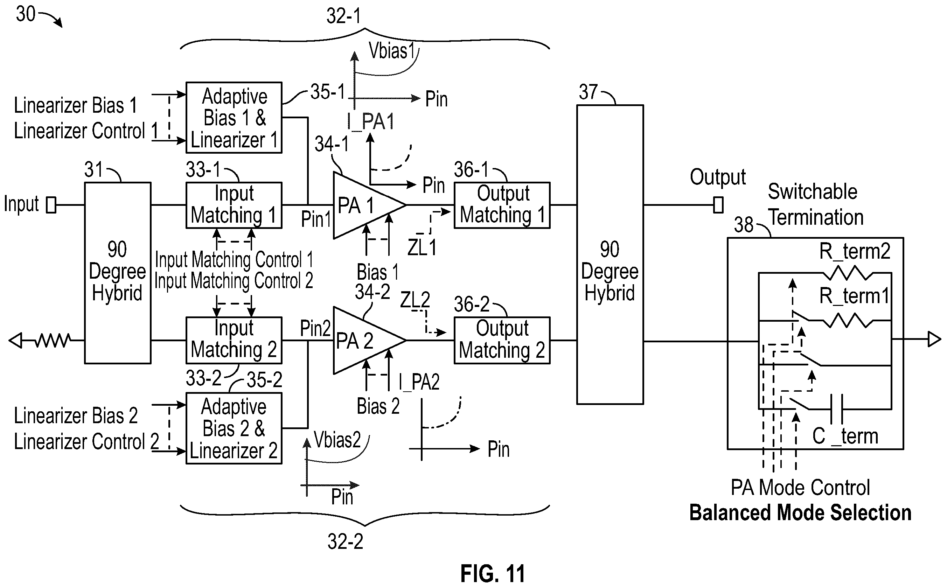

Figure 11 is a schematic diagram of a power amplifier circuit 30 of Figure 3A in balanced mode operation according to an embodiment. For higher VSWR variations, such as VSWR variations of greater than 2:1, the power amplifier circuit 30 can operate in balanced mode. The power amplifier circuit 30 in the balanced mode can achieve better PAE at the average operating power than the power amplifier circuit 30 in either Doherty mode or segmented mode.

The power amplifier circuit 30 can operate in balanced mode by controlling the first power amplifier core 34-1 and the second power amplifier core 34-2 to operate identical to (or substantially the same as) each other where the hybrid input splitter 31 and the hybrid output combiner 37 are connected in a balanced configuration. When load impedance variation and/or load VSWR take place at the output port, the balanced operation can cause a reflected signal to be absorbed by an isolation port of the hybrid output combiner 37 that is terminated by a 50 Ohm resistor. This can make the power amplifier circuit 30 in the balanced mode less sensitive to VSWR variations than in other modes.

Typically, efficiency of a balanced power amplifier circuit can follow the same efficiency behavior of the two individual power amplifier cores 34-1 and 34-2. Advantageously, using adaptive biasing for the power amplifier cores 34-1 and 34-2 can improve the PAE of the power amplifier circuit 30 in balanced mode at back-off operation.

The bias voltages Vbias1 and Vbias2 for the power amplifier cores 34-1 and 34-2 can be identical or substantially the same. These bias voltages Vbias1 and Vbias2 can be generated by respective adaptive bias and linearization circuits 35-1 and 35-2 that can generate bias voltages that follow input power for desirable back-off efficiency.

The input matching networks 33-1 and 33-2 can be controlled to be identical or substantially the same as each other. The input matching networks 33-1 and 33-2 can be in a state to achieve maximum or near maximum input power Pin at each input to a power amplifier core 34-1, 34-2.

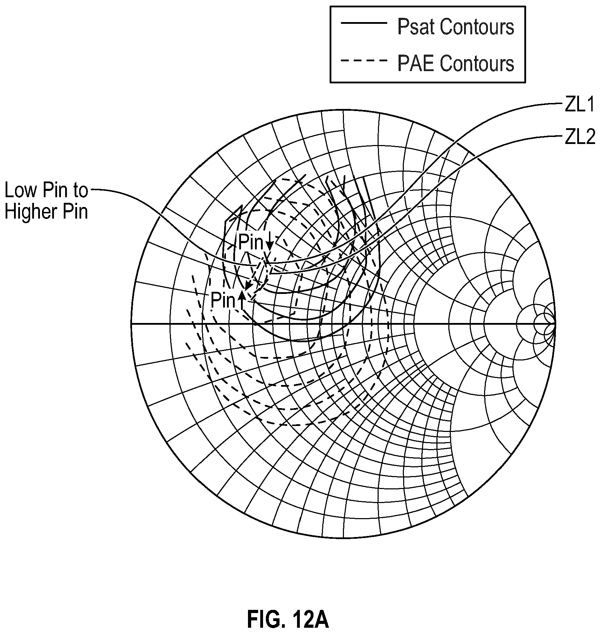

The adjustable termination impedance circuit 38 can provide a termination impedance for an identical or substantially the same load impedance for each power amplifier output as shown on Smith chart of Figure 12A. As shown in Figure 11, the adjustable termination impedance circuit 38 can select a termination resistor R_term2 for operating in the balanced mode. The termination resistor R_term2 can have an impedance of 50 Ohms. The adjustable termination impedance circuit 38 can select a different termination impedance for each of the balanced mode, the segmented mode, and Doherty mode.

The hybrid output combiner 37 can cancel the 90-degree phase shift between output signals from the power amplifier cores 34-1 and 34-2 for operating in the balanced mode.

Figure 12A is a Smith chart corresponding to the power amplifier circuit 30 in the balanced mode.

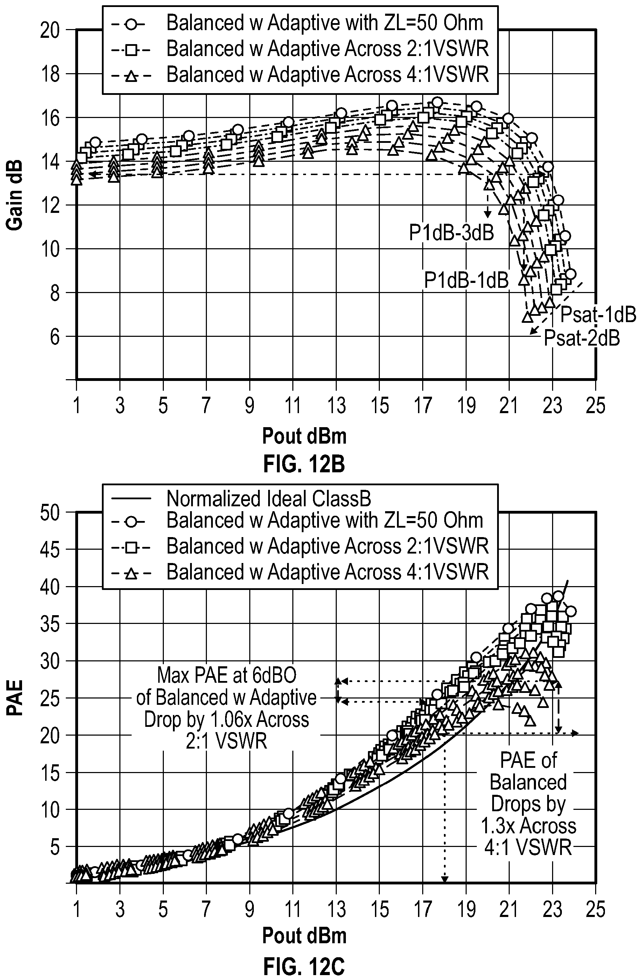

Figure 12B is a graph of gain versus output power for the power amplifier circuit of Figure 11. Figure 12C is a graph of PAE versus output power for the power amplifier circuit of Figure 11. In the graphs of Figures 12B and 12C, performance of the power amplifier circuit 30 in the balanced mode under different load conditions in shown.

With an optimum load condition where the load impedance is 50 Ohms, the power amplifier circuit 30 in balanced mode can achieve its peak performance with 27% PAE at 6 dBO, a 24.5 dBm maximum Psat, and desirable AM to AM flatness versus output power Pout, which results in a good linearity and relatively easy DPD.

At 2:1 load VSWR for balanced mode, the worst backed-off PAE drops by about 1.06x from its maximum value with optimum load while achieving 25.5% PAE. Also, the output power saturation Psat drops by 1 dB and AM to AM flatness can still achieve good linearity and relatively easy DPD, resulting in 1 dB lower P1dB.

At 4:1 load VSWR for balanced mode, the worst backed-off PAE drops by 1.3x from its maximum value with optimum load while achieving 20.7% PAE. Also, the Psat drops by 2 dB from its maximum value and AM to AM flatness is suitable to achieve good linearity and relatively easy DPD, resulting in 3 dB lower P1dB.

The graphs of Figures 12B and 12C indicate that the power amplifier circuit 30 in balanced mode has low VSWR sensitivity. The power amplifier circuit 30 in the balanced mode can have relatively low PAE improvement for the optimum load operation relative to when there is VSWR variation. The power amplifier circuit 30 can be suitable for greater than 2:1 VSWR variation operation. The power amplifier circuit 30 can operate in balanced mode for greater than 2:1 VSWR variation.

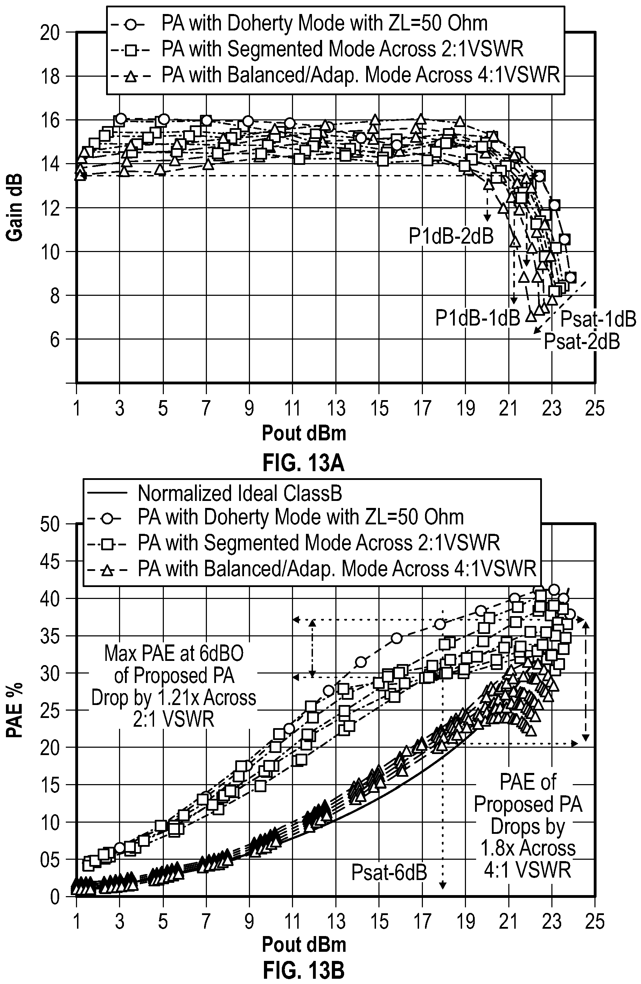

Figure 13A is a graph of gain versus output power for the power amplifier circuit 30 of Figure 3A for Doherty mode, segmented mode, and balanced mode. Figure 13B is a graph of PAE versus output power for the power amplifier circuit 30 of Figure 3A for Doherty mode, segmented mode, and balanced mode. The graphs of Figures 13A and 13B indicate that the power amplifier circuit 30 can achieves back off PAE across 4:1 VSWR better than a Class B power amplifier with an optimum load, low Psat and P1dB drop over VSWR, and an AM to AM flatness for relatively easy DPD and good linearity versus VSWR.

Table 2 summarizes performance of the power amplifier circuit 30 in different modes and overall performance when operating in the different modes.

**Table 2**

| | **At Optimum Load** | | **At 2:1 VSWR** | | **At 4:1 VSWR** | |
|---|---|---|---|---|---|---|
| | PAE at 6 dBO | P1dB | 6dBO PAE | Degradation in P 1 dB | 6dBO PAE | Degradation in P1dB |
| Multi-mode | *36.5%* | *21* | *30%* | *-1 dB* | *21*% | *-2 dB* |
| Doherty mode | *36.5%* | *21* | 24% | -10 dB | 12% | -15 dB |
| Segmented mode | 33% | 22 | *30%* | *-1 dB* | 16.5% | -9 dB |
| Balanced mode | 27% | 22 | 25.4% | -1 dB | *21*% | *-2 dB* |

Power amplifiers that operate with multiple mode of operation for desirable performance versus load variations and/or VSWR variations are disclosed. A power amplifier circuit can include two power amplifier cores. The power amplifier circuit can include a programmable bias, input matching, output matching, and adaptive bias and linearization circuit associated with each power amplifier core. The output power of the power amplifier cores can be combined with a hybrid output combiner. The hybrid output combiner can provide a 90 degree phase shift to a radio frequency signal received from one of the two power amplifier cores. The hybrid output combiner can have a port connected to an adjustable termination impedance circuit. The adjustable termination impedance circuit can provide a different termination impedance for each mode of operation.

The power amplifier circuit can operate in a first mode with high efficiency operation with a load modulation power amplifier architecture. The power amplifier circuit can operate in the first mode at or near optimum load conditions. The first mode can be a Doherty mode. In the Doherty mode, a first power amplifier core can be biased to operate as a Class AB or a Class B amplifier and the second power amplifier core can be biased to operate as a Class B or Class C amplifier. The adjustable termination impedance circuit can be in a state to provide quarter wavelength transmission line behavior for the first mode. The adjustable termination impedance circuit can provide a short circuit termination for the first mode.

The power amplifier circuit can operate in a second mode for VSWR variations up to 2:1 to achieve moderate PAE at the average operating power. The second mode can be segmented mode. In the segmented mode, (i) the first power amplifier core is biased differently than the second power amplifier core and (ii) both the first power amplifier core and the second power amplifier core are activated throughout the mode. The adjustable termination impedance circuit can be in a different state in the second mode than in the first mode. As an example, the adjustable termination impedance circuit can provide a resistive termination in the second mode.

The power amplifier circuit can operate in a third mode for VSWR variations greater than 2:1 to achieve better PAE at the average operating power than the first and second mode under such VSWR variations. The third mode can be balanced mode. In the balanced mode, a reflected signal can be absorbed by the port of the hybrid output combiner that is connected to the adjustable termination impedance circuit. The adjustable termination impedance circuit can be in a different state in the third mode than in the second mode and than in the first mode. The adjustable termination impedance circuit can provide a 50 Ohm resistive termination impedance in the third mode.

In the embodiments described above, apparatus, systems, and methods for multi-mode power amplifiers are described in connection with particular embodiments. It will be understood, however, that the principles and advantages of the embodiments can be used for any other systems, apparatus, or methods with a need for a power amplifier circuit in accordance with any suitable principles and advantages disclosed herein. Moreover, any suitable principles and advantages disclosed herein can be implemented in systems and in methods that include a power amplifier and transmit a radio frequency signal via one or more antennas.

The principles and advantages described herein can be implemented in various apparatuses. Examples of such apparatuses can include, but are not limited to, communications infrastructure such as wireless communications infrastructure, consumer electronic products, parts of the consumer electronic products, electronic test equipment, vehicular electronic products, industrial electronic products, etc. Electronic products can include, but are not limited to, base stations such as cellular base stations, access points, repeaters, relays, wireless communication devices, a user equipment, a mobile phone (for example, a smart phone), a hand-held computer, a tablet computer, a laptop computer, a wearable computing device, a vehicular electronics system, a radio, a wearable health monitoring device, etc. Further, apparatuses can include unfinished products.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings of the inventions provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments of the inventions have been described, these embodiments have been presented by way of example only, and are not intended to limit the scope of the disclosure. Indeed, the novel methods and systems described herein may be embodied in a variety of other forms. Furthermore, various omissions, substitutions and changes in the form of the methods and systems described herein may be made without departing from the spirit of the disclosure. The accompanying claims and their equivalents are intended to cover such forms or modifications as would fall within the scope and spirit of the disclosure. Accordingly, the scope of the present inventions is defined by reference to the claims.

### Numbered aspects

By way of non-limiting example, some aspects of the disclosure are set out in the following numbered clauses.
Numbered Clause 1. A power amplifier system comprising:
   a first power amplifier core configured to provide a first radio frequency signal;
   a second power amplifier core configured to provide a second radio frequency signal;
   an output combiner configured to receive the first radio frequency signal and the second radio frequency signal, the output combiner comprising an output port and an isolation port; and
   an adjustable termination impedance circuit electrically connected to the isolation port, the adjustable termination impedance circuit configured to provide different terminations to the isolation port in different modes, the different modes including a segmented power amplifier mode.
Numbered Clause 2. The power amplifier system of Numbered Clause 1, wherein the different modes include a Doherty mode.
Numbered Clause 3. The power amplifier system of Numbered Clause 1 or 2, wherein the different modes include a balanced mode.
Numbered Clause 4. The power amplifier system of any preceding Numbered Clause, wherein the adjustable termination impedance circuit is configured to adjust a termination impedance at the isolation port based on an indication of voltage standing wave ratio (VSWR) variation.
Numbered Clause 5. The power amplifier system of any preceding Numbered Clause, wherein the different modes include three modes.
Numbered Clause 6. The power amplifier system of Numbered Clause 5, wherein the three modes include a Doherty mode, the segmented power amplifier mode, and a balanced mode.
Numbered Clause 7. The power amplifier system of Numbered Clause 5 or 6, wherein the power amplifier system is configured to operate in a Doherty mode for voltage standing wave ratio (VSWR) variations in a range for Doherty mode, configured to operate in the segmented power amplifier mode for VSWR variations greater than the Doherty mode and below VSWR variations for a balanced mode, and configured to operate in the balanced mode for VSWR variations greater than for the segmented power amplifier mode.
Numbered Clause 8. The power amplifier system of any preceding Numbered Clause, wherein:
   the first power amplifier core is biased differently than the second power amplifier core in the segmented power amplifier mode; and
   both the first power amplifier core and the second power amplifier core are activated throughout the segmented power amplifier mode.
Numbered Clause 9. The power amplifier system of any preceding Numbered Clause, wherein:
   the adjustable termination impedance circuit is configured to provide a resistive termination in the segmented power amplifier mode; and
   the power amplifier system is configured to adaptively bias the second power amplifier core in the segmented power amplifier mode, and a bias signal for the second power amplifier core includes at least one first tone component with a non-zero frequency to cancel a non-linearity of the second power amplifier core in the segmented mode.
Numbered Clause 10. The power amplifier system of any preceding Numbered Clause, further comprising an antenna array, wherein the power amplifier system is configured to perform beam scanning using the antenna array, and wherein the adjustable termination impedance circuit is configured to adjust a termination impedance at the isolation port based on an indication of a beam angle.
Numbered Clause 11. The power amplifier system of Numbered Clause 10, further comprising a second multi-core power amplifier operable in the different modes, the second multi-core power amplifier configured to drive a second antenna of the antenna array, wherein the second multi-core power amplifier is configured to operate in a same mode as the first and second power amplifier cores.
Numbered Clause 12. The power amplifier system of any preceding Numbered Clause, wherein the output combiner is a hybrid combiner, and the hybrid combiner is configured to combine the second radio frequency signal with a phase shift in a range from 60 degrees to 130 degrees relative to the first radio frequency signal.
Numbered Clause 13. The power amplifier system of any preceding Numbered Clause, further comprising a hybrid input splitter configured to phase shift the second radio frequency signal by an angle in a range from 60 degrees to 130 degrees relative to the first radio frequency signal.
Numbered Clause 14. The power amplifier system of any preceding Numbered Clause, wherein:
   the first power amplifier core is included in a first power amplifier segment, the first power amplifier segment also including a first input matching circuit connected to an input of the first power amplifier core and a first adaptive bias circuit connected to the first power amplifier core, and the first input matching circuit and the first adaptive bias circuit are adjustable in the different modes; and
   the second power amplifier core is included in a second power amplifier segment, the second power amplifier segment also including a second input matching circuit connected to an input of the second power amplifier core and a second adaptive bias circuit connected to the second power amplifier core, and the second input matching circuit and the second adaptive bias circuit are adjustable in the different modes.
Numbered Clause 15. The power amplifier system of Numbered Clause 14, wherein first input matching circuit includes at least one controllable passive component, and the first input matching circuit is adjusted based on an indication of at least one of a reflected power change or load voltage standing wave ratio (VSWR) change.
Numbered Clause 16. The power amplifier system of Numbered Clause 14 or 15, wherein the first adaptive bias circuit and the second adaptive bias circuit are each configured to generate a respective bias signal that includes a direct current (DC) bias component and at least one non-DC radio frequency tone, and wherein a magnitude of DC bias component and a magnitude of the non-DC radio frequency tone are adjusted based on an indication of a reflected power change.
Numbered Clause 17. A power amplifier system comprising:
   a first power amplifier core configured to provide a first radio frequency signal;
   a second power amplifier core configured to provide a second radio frequency signal;
   a hybrid combiner configured to receive the first radio frequency signal and the second radio frequency signal, the hybrid combiner comprising an output port and an isolation port; and
   an adjustable termination impedance circuit electrically connected to the isolation port, the adjustable termination impedance circuit configured to provide different terminations to the isolation port in at least three different modes of the power amplifier system.
Numbered Clause 18. The power amplifier system of Numbered Clause 17, wherein the three different modes comprise a Doherty mode, a balanced mode, and another mode.
Numbered Clause 19. The power amplifier system of Numbered Clause 17 or 18, wherein the power amplifier system is configured to operate in the three different modes in different respective load voltage standing wave ratio variation ranges.
Numbered Clause 20. A method of multi-mode radio frequency signal amplification, the method comprising:
   amplifying a radio frequency signal with a power amplifier circuit in a segmented mode, the segmented mode being different than both Doherty mode and balanced mode, the power amplifier circuit including a first power amplifier core, a second power amplifier core, an output combiner configured to combine output signals from the first and second power amplifier cores, and an adjustable termination impedance circuit connected to a port of the output combiner;
   adjusting a termination impedance provided by the adjustable termination impedance circuit for a different mode relative to the segmented mode; and
   amplifying the radio frequency signal in the different mode.

## Claims

1. A power amplifier system comprising:
a first power amplifier core configured to provide a first radio frequency signal;
a second power amplifier core configured to provide a second radio frequency signal;
an output combiner configured to receive the first radio frequency signal and the second radio frequency signal, the output combiner comprising an output port and an isolation port; and
an adjustable termination impedance circuit electrically connected to the isolation port, the adjustable termination impedance circuit configured to provide different terminations to the isolation port in different modes, the different modes including a segmented power amplifier mode.

2. The power amplifier system of Claim 1, wherein the different modes include a Doherty mode and/or wherein the different modes include a balanced mode.

3. The power amplifier system of Claim 1 or 2, wherein the adjustable termination impedance circuit is configured to adjust a termination impedance at the isolation port based on an indication of voltage standing wave ratio (VSWR) variation.

4. The power amplifier system of any preceding Claim, wherein the different modes include three modes, preferably wherein the three modes include a Doherty mode, the segmented power amplifier mode, and a balanced mode,
preferably wherein the power amplifier system is configured to operate in a Doherty mode for voltage standing wave ratio (VSWR) variations in a range for Doherty mode, configured to operate in the segmented power amplifier mode for VSWR variations greater than the Doherty mode and below VSWR variations for a balanced mode, and configured to operate in the balanced mode for VSWR variations greater than for the segmented power amplifier mode.

5. The power amplifier system of any preceding Claim, wherein:
the first power amplifier core is biased differently than the second power amplifier core in the segmented power amplifier mode; and
both the first power amplifier core and the second power amplifier core are activated throughout the segmented power amplifier mode.

6. The power amplifier system of any preceding Claim, wherein:
the adjustable termination impedance circuit is configured to provide a resistive termination in the segmented power amplifier mode; and
the power amplifier system is configured to adaptively bias the second power amplifier core in the segmented power amplifier mode, and a bias signal for the second power amplifier core includes at least one first tone component with a non-zero frequency to cancel a non-linearity of the second power amplifier core in the segmented mode.

7. The power amplifier system of any preceding Claim, further comprising an antenna array, wherein the power amplifier system is configured to perform beam scanning using the antenna array, and wherein the adjustable termination impedance circuit is configured to adjust a termination impedance at the isolation port based on an indication of a beam angle,
preferably further comprising a second multi-core power amplifier operable in the different modes, the second multi-core power amplifier configured to drive a second antenna of the antenna array, wherein the second multi-core power amplifier is configured to operate in a same mode as the first and second power amplifier cores.

8. The power amplifier system of any preceding Claim, wherein the output combiner is a hybrid combiner, and the hybrid combiner is configured to combine the second radio frequency signal with a phase shift in a range from 60 degrees to 130 degrees relative to the first radio frequency signal.

9. The power amplifier system of any preceding Claim, further comprising a hybrid input splitter configured to phase shift the second radio frequency signal by an angle in a range from 60 degrees to 130 degrees relative to the first radio frequency signal.

10. The power amplifier system of any preceding Claim, wherein:
the first power amplifier core is included in a first power amplifier segment, the first power amplifier segment also including a first input matching circuit connected to an input of the first power amplifier core and a first adaptive bias circuit connected to the first power amplifier core, and the first input matching circuit and the first adaptive bias circuit are adjustable in the different modes; and
the second power amplifier core is included in a second power amplifier segment, the second power amplifier segment also including a second input matching circuit connected to an input of the second power amplifier core and a second adaptive bias circuit connected to the second power amplifier core, and the second input matching circuit and the second adaptive bias circuit are adjustable in the different modes.

11. The power amplifier system of Claim 10, wherein first input matching circuit includes at least one controllable passive component, and the first input matching circuit is adjusted based on an indication of at least one of a reflected power change or load voltage standing wave ratio (VSWR) change.

12. The power amplifier system of Claim 10 or 11, wherein the first adaptive bias circuit and the second adaptive bias circuit are each configured to generate a respective bias signal that includes a direct current (DC) bias component and at least one non-DC radio frequency tone, and wherein a magnitude of DC bias component and a magnitude of the non-DC radio frequency tone are adjusted based on an indication of a reflected power change.

13. A power amplifier system comprising:
a first power amplifier core configured to provide a first radio frequency signal;
a second power amplifier core configured to provide a second radio frequency signal;
a hybrid combiner configured to receive the first radio frequency signal and the second radio frequency signal, the hybrid combiner comprising an output port and an isolation port; and
an adjustable termination impedance circuit electrically connected to the isolation port, the adjustable termination impedance circuit configured to provide different terminations to the isolation port in at least three different modes of the power amplifier system.

14. The power amplifier system of Claim 13, wherein the three different modes comprise a Doherty mode, a balanced mode, and another mode
and/or
wherein the power amplifier system is configured to operate in the three different modes in different respective load voltage standing wave ratio variation ranges.

15. A method of multi-mode radio frequency signal amplification, the method comprising:
amplifying a radio frequency signal with a power amplifier circuit in a segmented mode, the segmented mode being different than both Doherty mode and balanced mode, the power amplifier circuit including a first power amplifier core, a second power amplifier core, an output combiner configured to combine output signals from the first and second power amplifier cores, and an adjustable termination impedance circuit connected to a port of the output combiner;
adjusting a termination impedance provided by the adjustable termination impedance circuit for a different mode relative to the segmented mode; and
amplifying the radio frequency signal in the different mode.
